# EUROPEAN PATENT SPECIFICATION

(11) **EP 1 069 209 B1**
(45) Date of publication and mention of the grant of the patent: **06.10.2004**
(21) Application number: 99202376.2
(22) Date of filing: 16.07.1999
(51) Int. Cl.: C23C 18/16

(54) **Process for plating plastics using a catalytic filler**
Verfahren zum Plattieren von Kunstoffen unter Verwendung eines katalitischen Fuellstoffes
Procédé de placage de matières plastiques à l'aide d'une charge catalytique

(43) Date of publication of application: 17.01.2001
(73) Proprietor: Enthone-OMI (Benelux) B.V., 5222 BG 's-Hertogenbosch (NL)
(72) Inventor: Hartogs, Matty J., 5237 PT 's-Hertogenbosch (NL); Pingler, Uwe, 42657 Solingen (DE); Heyer, Joachim, 53819 Neun Kirchen (DE); Hendriks, Jan J.M., 5491 DA Sint Oedenrode (NL)
(74) Representative: Stenger, Watzke & Ring Patentanwälte

(56) References cited:
- GB-A- 979 779
- US-A- 4 767 665

## Description

The present invention relates to an improved process for plating plastics using a catalytic filler. More specifically, the present invention relates to electroless plating.

There is a growing need for plating non electrically conductive plastic surfaces with metals for application in e.g. circuit boards, shields for electromagnetic radiation in electronic devices, etc.

To obtain the desired metal plating of plastics, electroless plating using a catalytic material which is present on the surface of the article to be plated can be applied. The catalyst usually comprises PdCl₂, silver compounds or ferrous phosphides, which are present in the form of small particles on the surface of the article to be plated. In order to deposit the metal, the article is submerged in a solution of a salt of the desired metal and an appropriate reducing agent. Under suitable conditions the catalyst particles cause the metal ions to be reduced from the solution to form a metal plating. This step can be followed by one or more additional electroless plating steps, using additional solutions or by conventional electrochemical plating steps. In this way a plating of the desired thickness can be obtained.

A common technique to apply the catalyst material to the surface of the article is by using a lacquer in which the catalyst material is present. Usually such a lacquer comprises acrylic resins, polyurethane (PUR) (crosslinked or non-crosslinked) resins, and the like. After applying the liquid lacquer to the article, it is heated, which causes the solvent to evaporate and, subsequently, the resin to harden. This type of plating proves effective for plating acrylonitrile-butadiene-styrene copolymer (ABS), polycarbonate (PC) blends, PC and others.

Another technique to apply the catalyst material, which technique generally uses Pd salts, is to dip the pretreated plastic parts in a palladium based activator solution. After the proper pretreatment the catalyst will absorb onto the polymer surface.

An obvious drawback of the first mentioned technique is that it is difficult or even impossible to plate articles with surfaces that are not easily accessible for the lacquer. For example, drill holes in printed circuit boards or articles having a complex geometry cannot be coated successfully with a lacquer filled with catalyst. Selective plating can only be achieved by using masking techniques when applying the lacquer. The second technique, which uses immersion in catalyst solution, does not provide any selectivity at all.

Another disadvantage is the requirement that adhesion of the lacquer has to be sufficiently strong. This cannot be achieved for all types of polymer. For example, liquid crystal polymers like Vectra® E 820 I and polymers like poly(butylene terephthalate) (PBT), polyethylene (PE), polypropylene (PP) or nylon cannot be successfully plated using a lacquer filled with catalyst.

An alternative approach for the metal plating of plastic articles is the mixing in the bulk of the plastic of the article to be plated, followed by the above mentioned electroless plating step, optionally followed by another electroless or an electrochemical plating step.

US-A-4,767,665 discloses an electroless plating process for plastic materials. The plastic articles described in this patent are prepared by compounding metallic phosphide compounds in the plastic article.

According to US-A-4,767,665 the metallic particles are exposed by carrying out a surface treatment, such as a mechanical or thermal treatment. This is then followed by plating by means of the above mentioned electroless process, e.g. by placing the articles in baths of copper salt solutions in case a copper plating is desired.

The method disclosed in US-A-4,767,665 does not solve the above-mentioned problem of plating surfaces of complex shaped articles.

Plating surfaces of complex shaped articles is of particular relevance in plating moulded interconnected devices in which often complex structures appear, which in addition require selective plating. It is also relevant for through hole copper plating of printed circuit boards.

Moreover, all of the known processes for plating plastics using catalytic fillers have in common that the initiation process of electroless plating is slow. This is reflected in the period of time that is required to observe the first signs of metal deposits. Usually this is 20 minutes or more.

In addition, with known plating techniques the means of achieving selectivity for the metal to deposit on the treated regions of the surface are limited, resulting in a final product with an insufficient resolution, unless laborious phototechniques are used. This is especially of importance in the production of printed circuit boards and moulded interconnected devices.

The present inventors have found that when the surface treatment required to expose the catalytic particles is performed using an alkaline solution, and this is followed by an activation of the exposed particles by a treatment with acid, the problems mentioned above can be overcome.

According to the present invention a plating process is provided comprising the following steps:
a) compounding a granular plastic with a catalyst suitable for an electroless plating reaction, optionally with one or more fillers,
b) forming a shaped body from the product of step a),
c) removal of at least part of the material from the surface of the product of step b) to expose part of said catalyst,
d) treatment with an acid to activate the exposed catalyst of step c), and
e) metal plating of the product of step d) in an electroless metal bath.

To form moulded interconnected devices, second and further moulding steps using a non-filled plastic may be carried out between steps b) and c), providing selectivity.

Using the process according to the invention, a plating rate of about 2 µm/h or higher can be obtained. In addition, the time in which initial deposition of metal is observed is less than about 15 minutes, and sometimes even less than about 10 minutes.

It is also possible to obtain a good and selective plating on complex shaped articles.

According to the present invention the removal of the plastic in step c) is preferably carried out by dissolving the plastic using an alkaline solution. Alternatively any other suitable removal technique can be used.

Suitable plastics that can be used for the plating process according to the invention are polymers which are known to be attacked by alkaline solutions. When treating such plastics with strong alkaline materials such as sodium hydroxide, the catalyst particles incorporated therein are partly set free. If such a treated material is brought in an electroless plating bath a better initiation is obtained, and the copper adheres better to the plastic. Preferred are liquid crystal polymers (LCP), such as Vectra® E 820 I, A 530, C 810, or other liquid crystal polymers sold under the registered trade names Ekkcel, Xydar and Utrax, which are all based on long chain macromolecules of acrylate copolymers comprising reinfacing groups such as p-hydroxy benzoate or 2,6-naphthalene diacids or -diols; etc., or a polymer chosen from the group consisting of ABS, ABS/PC, poly(ethylene imine) (PEI), polystyrene (PS), polyethyl-ether-ketone (PEK), polyether sulphone (PES), rubbers, nylon, poly(ethylene terephthalate) (PET) poly(butylene terephthalate), or blends like PC/LCP or PBT/PC. Particularly preferred are PBT, PC, LCP and alkaline etchable nylons.

In step (a) the granular plastic is compounded with a catalyst. In this step fillers optionally may be present. Suitable fillers are glass particles, dolomite, graphite, phosphates, sulfates, or more in detail, sulphates, phosphates and carbonates of potassium, barium and/or calcium. Fillers are added to improve mechanical strength, for coloring, as flame retardant, as "etchable" component or just as a cheap bulk material to lower the price of the material to be made.

Following the exposure step, the acid treatment is performed to activate the exposed particles. Acids that are suitable for this purpose are chosen from the group consisting of solutions of strong mineral and/or organic acids with a pH of below 2, preferably <1. Acids which can suitably be used in step (d) are sulphuric acid, hyrochloric acid, methane sulphonic acid, sulphamic acid, acetic acid, glycine, phosphoric acid, oxalic acid, naphthalene sulphonic acid, maleic acid, benzene sulphonic acid, trichloro acetic acid and chromic acid.

The catalyst material which is present in the plastic comprises phosphides, preferably ferrous phosphides, optionally mixed with other catalytic compounds, such as silver compounds, for example AgNO₃ or organo silver compounds; palladium compounds or metals such as palladium, nickel, silver or mixtures thereof.

In a preferred embodiment, the forming of a shaped body in step b) is carried out by injection moulding.

The invention will now be illustrated with examples, which are not intended to limit the scope of the invention.

### EXAMPLE 1

Samples of Vectra® E 820 I were compounded with ferrous phosphide in an amount of 15 weight-%, drawn on the total composition, using a screw extruder. The samples were subsequently etched using a sodium hydroxide solution of ca. 10 N, at 70°C, 15 minutes followed by activation at room temperature using sulphuric acid of ca. 6% for 1 minute.

The samples where submerged in a chemical copper bath (Enplate™ Cu 872 I/873) at 46°C and the plating rate was monitored.

After 5 minutes the first sign of copper deposition was observed. After 12 minutes a closed, viz. continuous metal layer was observed.

The plating rate was 2-2.5 µm/h and the final copper thickness was 20 µm.

The plated samples were subjected to the ASTM 3359-83-B tape test, wherein the binding between the plated metal layer and the substrate layer is evaluated. From this test, it becomes clear that the binding is good (grade 4 to 5 on a scale of 0 to 5).

### EXAMPLE 2

Samples of Vecta® E 820 I filled with ferrous phosphide where prepared as in the previous example. This material was formed into plates, in which plates holes of different length and diameter were drilled. The holes where wider than 0.15 mm. Part of the holes were etched with 10 N sodium hydroxide. Part of the holes from the etched portion were treated with sulphuric acid 2.5%.

The following results were obtained:

| Holes | Time to first sign of copper [minutes] | Plating rate [µm/h] |
|---|---|---|
| non treated | ∞ | 0 |
| only etched | ≥ 15^{*)} | 2^{**)} |
| etched and acid treated | 5 | 2 |

| | | |
|---|---|---|
| *) : Depending on time between etching and plating. | | |
| **): Once the initiation is complete. | | |

## Claims

1. Process for electroless plating of plastics comprising the steps of:
a) compounding a granular plastic with a catalyst suitable for an electroless plating reaction,
b) forming a shaped body from the product of step a),
c) removal of at least part of the material from the surface of the shaped body of step b) to expose part of said catalyst,
d) treatment with an acid to activate the exposed catalyst of step c), and
e) metal plating of the product of step d) in an electroless metal bath.

2. Process according to claim 1 in which the removal of the plastic of step c) is carried out by contacting the shaped body with an alkaline solution.

3. Process according to claim 1 or claim 2, wherein step b) is carried out by injection moulding.

4. Process according to any of the preceding claims in which the acid in step d) is a solution of a mineral and/or an organic acid with a pH of less than 2, preferably less than 1.

5. Process according to any of the preceding claims in which said catalyst comprises phosphides, preferably ferrous phosphides, optionally mixed with silver, silver compounds, palladium, palladium compounds, nickel or mixtures thereof.

6. Process according to any of the preceding claims in which the plastic is a liquid crystal polymer chosen from the group consisting of a polyacrylate copolymer such as acrylate copolymer reinforced with p-hydroxy benzoate or 2,6-naphthalene diacid or diol groups; acrylonitrile-butadiene-styrene copolymer, acrylonitrile-butadiene-styrene copolymer/polycarbonate blends, polycarbonate, poly(ethylene imine), polystyrene, poly(ethylether ketone) (PEK), polyether sulfphone (PES), rubbers, nylon, poly(ethylene terephthalate), and blends thereof.

7. Process according to any of the preceding claims in which the metal to be deposited from the metal bath is selected from the group consisting of copper, nickel, silver, cobalt, gold, palladium, tin, and mixtures thereof.

8. Process according to any one of the preceding claims, wherein in step (a) also a filler is compounded with the plastic and catalyst.

## Patentansprüche

1. Verfahren zur stromlosen Metallisierung von Kunststoffen, aufweisend die Schritte:
a) Mischen eines granulierten Kunststoffes mit einem für stromlose Metallisierungsreaktionen geeigneten Katalysator,
b) Herstellen eines Formkörpers aus dem Produkt des Schrittes a),
c) Entfernen zumindest eines Teils des Materials von der Oberfläche des Formkörpers aus Schritt b) zur Freisetzung eines Teils des Katalysators,
d) Behandlung mit einer Säure zur Aktivierung des freigesetzten Katalysators aus Schritt c), und
e) Metallisieren des Produktes aus Schritt d) in einem stromlosen Metallisierungsbad.

2. Verfahren gemäß Anspruch 1, **dadurch gekennzeichnet, daß** die Entfernung des Kunststoffes nach Schritt c) durch Kontaktierung des Formkörpers mit einer alkalischen Lösung ausgeführt wird.

3. Verfahren gemäß Anspruch 1 oder 2, **dadurch gekennzeichnet, daß** Schritt d) durch Spritzgießen ausgeführt wird.

4. Verfahren nach einem der vorhergehenden Ansprüche, **dadurch gekennzeichnet, daß** die Säure in Schritt d) eine Lösung einer Mineralund/oder organischen Säure mit einem pH-Wert < 2, vorzugsweise < 1, ist.

5. Verfahren nach einem der vorhergehenden Ansprüche, **dadurch gekennzeichnet, daß** der Katalysator Phosphide, vorzugsweise Eisenphosphide, wahlweise gemischt mit Silber, Silberverbindungen, Palladium, Palladiumverbindungen, Nickel oder Mischungen davon aufweist.

6. Verfahren nach einem der vorhergehenden Ansprüche, **dadurch gekennzeichnet, daß** der Kunststoff ein Flüssigkristallpolymer ausgewählt aus der Gruppe bestehend aus Polyacrylatcopolymer wie Acrylatcopolymer verstärkt mit p-Hydroxybenzoat oder 2,6-Naphtalendisäure oder Diolgruppen; Acrylonitril-Butadien-Styrolcopolymer, Acrylonitril-Butadien-Styrolcopolymer/Copoly-carbonatmischungen, Polycarbonate, Poly(ethylenimine), Polystyrole, Poly(ethyletherketone) (PEK), Polyethersulphone (PES), Gummi, Nylon, Poly(ethylenterephthalate), und Mischungen dieser ist.

7. Verfahren nach einem der vorhergehenden Ansprüche, **dadurch gekennzeichnet, daß** das aus dem Metallisierungsbad abzuscheidende Metall ausgewählt ist aus der Gruppe bestehend aus Kupfer, Nickel, Silber, Kobalt, Gold, Palladium, Zinn und Mischungen dieser.

8. Verfahren nach einem der vorhergehenden Ansprüche, **dadurch gekennzeichnet, daß** in Schritt a) auch ein Füllmaterial dem Kunststoff und Katalysator beigemischt wird.

## Revendications

1. Procédé de dépôt autocatalytique de matières plastiques comprenant les étapes consistant à :
a) mélanger une matière plastique granuleuse à un catalyseur approprié à une réaction de dépôt autocatalytique,
b) former un corps moulé à partir du produit de l'étape a),
c) enlever au moins une partie du matériau de la surface du corps moulé de l'étape b) afin d'exposer une partie dudit catalyseur,
d) traiter avec un acide afin d'activer le catalyseur exposé de l'étape c), et
e) réaliser un revêtement métallique du produit de l'étape d) dans un bain autocatalytique métallique.

2. Procédé selon la revendication 1, dans lequel l'enlèvement de la matière plastique de l'étape c) est effectué par la mise en contact du corps moulé avec une solution alcaline.

3. Procédé selon la revendication 1 ou selon la revendication 2, dans lequel l'étape b) est effectuée par moulage par injection.

4. Procédé selon l'une quelconque des revendications précédentes, dans lequel l'acide dans l'étape d) est une solution d'un acide minéral et/ou d'un acide organique ayant un pH inférieur à 2, de préférence un pH inférieur à 1.

5. Procédé selon l'une quelconque des revendications précédentes, dans lequel ledit catalyseur comprend des phosphures, de préférence des phosphures ferreux, facultativement mélangés à de l'argent, des composés d'argent, du palladium, des composés de palladium, du nickel ou les mélanges de ceux-ci.

6. Procédé selon l'une quelconque des revendications précédentes, dans lequel la matière plastique est un polymère cristal liquide choisi dans le groupe comprenant un copolymère de polyacrylate tel que le copolymère d'acrylate renforcé par des groupes diols ou diacides de p-hydroxybenzoate ou de 2,6-naphtalène ; le copolymère d'acrylonitrile-butadiène-styrène, les mélanges de copolymère d'acrylonitrile-butadiène-styrène et de polycarbonate, le polycarbonate, la polyéthyléneimine, le polystyrène, le polyéthercétone (PEK), le polyéthersulfone (PES), les caoutchoucs, le nylon, le polyéthylène téréphtalate, et les mélanges de ceux-ci.

7. Procédé selon l'une quelconque des revendications précédentes, dans lequel le métal devant être déposé à partir du bain métallique est choisi dans le groupe comprenant le cuivre, le nickel, l'argent, le cobalt, l'or, le palladium, l'étain, et les mélanges de ceux-ci.

8. Procédé selon l'une quelconque des revendications précédentes, dans lequel dans l'étape (a) également, une charge est mélangée avec la matière plastique et le catalyseur.
